# EUROPEAN PATENT SPECIFICATION

(11) **EP 3 530 765 B1**
(45) Date of publication and mention of the grant of the patent: **03.04.2024**
(21) Application number: 19158463.0
(22) Date of filing: 21.02.2019
(51) Int. Cl.: C22C 21/06, C22F 1/047

(54) **METHOD TO MANUFACTURE AL-MG-SC-ZR ALLOYS FOR SOLAR CELL CONNECTORS**
HERSTELLUNGSVERFAHREN ZU AL-MG-SC-ZR-LEGIERUNGEN FÜR SOLARZELLENVERBINDUNGEN
PROCÉDÉ DE FABRICATION D'ALLIAGES AL-MG-SC-ZR POUR CONNECTEURS DE CELLULES SOLAIRES

(30) Priority: 27.02.2018 DE 102018202915
(43) Date of publication of application: 28.08.2019
(73) Proprietor: Airbus Defence and Space GmbH, 82024 Taufkirchen (DE)
(72) Inventor: LENCZOWSKI, Blanka, 85579 Neubiberg (DE); ZIMMERMANN, Claus, 81371 München (DE); NOEMAYR, Christel, 81241 München (DE); STEINS, Wiebke, 85737 Ismaning (DE); GEIGER, Frank, 63594 Hasselroth (DE); REICHELT, Stephan, 36284 Hohenroda Mansbach (DE)
(74) Representative: Isarpatent

(56) References cited:
- EP-A1- 2 871 642
- Anonymous: "Aerospace Aluminum AA5024 AlMgSc Sheet", Aleris Corporation- 3rd edition, vol. 13, no. 1, 1 January 2013 (2013-01-01), XP055582942,

## Description

The present invention relates to a method for producing a metal foil composed of an aluminium-magnesium alloy which comprises scandium and zirconium, to a metal foil produced in accordance with the method, and to the use thereof in a solar cell array and/or in aerospace.

For the operation of satellites, solar cells are nowadays commonly used. In order to interconnect a plurality of solar cells in series with one another and hence to adapt the resulting string to the required operating voltage of a satellite, cell connectors are used. In orbit, these connectors are customarily exposed to the same environmental influences as the solar cells themselves, and may accordingly suffer degradation. Because the solar cells represent the true "heart" of the satellites, damage to the connectors or cell connectors which bind and connect the solar cells can lead to loss of performance and therefore jeopardize the mission of the satellite and/or its payload.

Present connectors made from materials such as silver, gold, molybdenum and MoAg are punched out from thin foils with a thickness of around 12-38 µm and are contacted to the cell by welding. When xenon-operated ion drives are employed, which may in future be employed to an increased extent, however, the present connector materials may be damaged by environmental influences during operation in a satellite, since Ag and Au are unstable with respect to xenon ion erosion and Ag, furthermore, is also not stable with respect to atomic oxygen (ATOX).

EP 2871642 discloses new materials for producing metal foils wherein aluminium is accompanied by scandium and zirconium.

Against this background, the object of the present invention is that of providing an improved method for producing metal foils based on aluminium-magnesium metal alloys which comprise scandium and zirconium, and also improved connectors for solar cells in satellites, using such metal foils.

In accordance with the invention this object is achieved by a method having the features of Claim 1. The present invention relates more particularly to the materials technology for realizing thin metal foils having a final thickness of, for example, up to 1 µm or up to about 10 µm, composed of aluminium-magnesium alloys with scandium and zirconium selected from aluminium alloys from groups AA5024 and/or AA5028, such as, for example, the AA5024/AA5028 Scalmalloy^{®} group, and the associated process technologies, and also the use of the foils, especially for solar cells, as connectors, especially for space applications.

Advantageous embodiments and developments are apparent from the further dependent claims and also from the description with reference to the figures.

The concept on which the present invention is based is that by targeted production of a metal foil composed of an aluminium-magnesium alloy comprising scandium and zirconium selected from aluminium alloys from groups AA5024 and/or AA5028, there are advantageous properties, present in a parent intermediate, such as in a sheet, for example, that can be retained in the foil itself.

Accordingly, with the method of the invention, it is possible to produce metal foils which exhibit high stability in particular towards Xe ions and, generally, high cyclic stability and ion erosion resistance, while also being highly resistant to atomic oxygen (ATOX). Moreover, these foils at the same time possess electrical conductivity and very good weldability, by means for example of resistance spot welding, ultrasonic spot welding, laser welding and friction stir welding (FSW). Within a temperature range of around -190°C to 200°C, as required in particular in space travel, for satellites, for example, the material of the metal foils is stable with respect to rapidly changing thermal stresses, having stable mechanical properties. This is important for missions both in a geostationary orbit (GEO) and in a low Earth orbit (LEO). In particular for connectors in satellites and other articles employed in aerospace, furthermore, it is vital that these connector elements withstand the strains and vibrations resulting from mechanical and acoustic oscillations during the take-off of a rocket. Through the targeted production operation, this can be ensured in particular in metal foils which are produced by the method of the invention.

In the method of the invention for producing a metal foil composed of an aluminium-magnesium alloy which comprises scandium and zirconium, the first step is to provide an intermediate of an aluminium-magnesium alloy which comprises scandium and zirconium, wherein the aluminium-magnesium alloy which comprises scandium and zirconium is selected from aluminium alloys from groups AA5024 and/or AA5028. There are no particular limitations on this intermediate, provided that it consists of an aluminium-magnesium alloy which comprises scandium and zirconium. There are no particular limitations here on the form of the intermediate, and the intermediate may be, for example, a sheet or a slab, a profile, a billet, a rod, a bar, a tube or the like, especially a sheet.

It is advantageous that the intermediate consists of an aluminium-magnesium alloy which comprises scandium and zirconium. These materials are outstandingly suitable for applications in aerospace and profit in particular from the sequence of steps in the method of the invention, since in these materials in particular it is possible to prevent substantially any change in the material as a result of the method. The qualities possessed by Al-Mg alloys with Sc and Zr include better mechanical properties, since in these alloys there is also an additional strength-boosting effect of the solid solution strengthening of Mg in aluminium. Furthermore, with the elements Sc and Zr, the microstructure can be stabilized during rolling down to low thicknesses, and so there is no recrystallization of the kind that may occur, for example, at relatively high levels of Mg in supersaturated mixtures and at relatively high temperatures. The result is therefore a fine grain structure with high mechanical properties. Another outcome of this is a greater number of grain boundaries, which promote finer distribution of the Mg phase, and improved corrosion resistance. Furthermore, Al-Mg alloys which comprise Sc and Zr are weldable, and the stability with respect to ATOX is good. Accordingly, we have achieved a fine grain structure having high mechanical properties, and, moreover, there are a greater number of grain boundaries, which favours finer distribution of the Mg phase and also contributes to the better corrosion resistance.

According to certain embodiments, the intermediate, a sheet for example, has a thickness of 0.1 to 10 mm, for example around 6 - 0.4 mm.

The material of the intermediate has been selected here on the basis in particular of the requirements for connector materials in space travel, and a variety of materials have been considered. The connectors or cell connectors here are elements which are able to join at least two solar cells to one another and/or to provide suitable binding of solar cells to a device to be loaded with them, such as a satellite, for instance.

The considerations and also to some extent requirements to which the connector materials are subject include the following:
It is first necessary to ensure sufficient thermal stability from -196°C (cryogenic) up to at least 200°C with thermomechanical interactions, reflecting the temperature regime for satellite operation. Furthermore, these materials are to be resistant to ATOX and ion erosion, as already observed above. For effective binding, moreover, sufficient electrical conductivity and thermal stability within the required temperature range are needed. For the binding, furthermore, there are advantages to excellent weldability, such as laser weldability or ultrasonic weldability, for example, and also to corrosion resistance.

For use in space travel, such as for satellites, moreover, there are advantages to materials of low density with high mechanical and dynamic properties and to a low coefficient of thermal expansion (CTE). For production moreover, it is of advantage if the material is available in the form of foil with thicknesses in the range of 5 - 50 µm, preferably 8 - 30 µm, more particularly 10- 26 µm, and if the production operation can be automated with short transit times. It is further advantageous if the foil produced does not require additional coating in order to establish the electrical conductivity and/or to ensure weldability and corrosion protection. The materials used to date for connectors in satellites, such as Kovar (NiFeCo alloy) or molybdenum, typically require an additional coating with silver, for the reasons given.

Additionally, the foil ought advantageously to be able to be brought into a desired form easily by punching and/or stamping, and not to require costly and inconvenient etching operations in order to define a desired geometry. Aluminium alloys are known to exhibit high stability with respect to xenon ion erosion, and so this group of materials was looked at more closely, particularly in conjunction with magnesium. Since, however, not all of the materials in the group possess sufficient strength at elevated temperature and since, for example, the conventional aluminium materials have thermal stabilities of at most up to around 150°C, a closer look was taken in particular at aluminium alloys with scandium and zirconium such as AA5024/KO8242, for example, which are available as an intermediate having a material thickness of around 6 - 0.4 mm, for example. The scandium and zirconium, in addition to intensive particle hardening by means of the thermally stable AIScZr precipitation, have the effect of producing a finer grain in the cast structure and preventing recrystallization during rolling. The precipitates are able to stabilize the properties of the material at temperatures of up to 400°C, and also to improve the weldability. Aluminium-magnesium alloys which comprise scandium and zirconium are exotic in metallurgy, since they combine solid solution hardening with Mg in Al with precipitation hardening with Al and Sc and Zr.

The aluminium-magnesium alloy which comprises scandium and zirconium is selected from aluminium alloys from groups AA5024 and/or AA5028 (according to EN 573-3/4), and selected more particularly from the Scalmalloy^{®} group, which possess, in particular, the advantageous materials properties above and in which these properties can be retained by means of the method of the invention. These alloys in particular are suitable for solar cell connectors and for automated production of the connectors, and also for possible integration to a solar cell, preferably by means of welding. Cell connectors with aluminium alloys from groups AA5024 and/or AA5028 and especially Scalmalloy^{®} cell connector technology, are able to achieve a multiple lifetime of solar panels, with thermal stability in the temperature range from around 200°C up to around 400°C, and so bring massive economic advantages and better competitiveness for the solar panel technology, particularly for space applications. With the aluminium alloys from groups AA5024 and/or AA5028 and especially Scalmalloy^{®} alloys, in particular, the present materials technology can be employed at up to around 400°C.

After it has been provided, the intermediate, for example a sheet, is rolled out by hot and/or cold rolling, especially cold rolling, to a thickness of 5 to 50 µm, preferably 8 - 30 µm, more particularly 10 - 26 µm. Cold rolling here is the shaping of the intermediate, for example a flat wide product such as a sheet or a slab, below its recrystallization temperature using mechanical apparatuses, in particular at room temperature of, for example, around 20 - 25°C, e.g. around 25°C, i.e. without heating of the material. Hot rolling, correspondingly, takes place at a higher temperature.

Rolling-out takes place in a plurality of steps. The rolling-out is not subject, moreover, to any particular limitation with regard to the rolling apparatus and/or the rolling speed. According to certain embodiments, rolling takes place at a rolling speed of less than 50 m/min, preferably less than 40 m/min, more preferably less than 30 m/min, more particularly less than 20 m/min, e.g. 2 to 18 m/min, e.g. 5 to 15 m/min, e.g. 5 to 8 m/min or 10 to 15 m/min. The aim here in particular was for manufacturing with a focus on high quality and reproducibility. For this reason, preference is given to working with rolling speeds that are low overall, since such speeds allow more effective metering and control of the belt tensions during rolling, and at the same time prevent uncontrolled heating in the roll nip, caused by the dissipation of forming heat; this has been shown in particular to be advantageous for the alloys used in the present case, in order to retain their structure and the resultant advantages, as specified.

At least once between two steps of the rolling-out interim heat treatment takes place at a temperature of 200 - 450°C for a period of 3 - 6 h. According to certain embodiments, however, there are more than two steps of rolling-out, i.e. three or more, e.g. three, four, five, six, seven, eight, nine, ten, eleven or more, and there is multiple interim heat treatment between the steps of rolling-out, with interim heat treatment carried out, for example, two, three, four, five, six, seven, eight, nine, ten or more times. The steps of rolling-out in this case may also be combined into a rolling campaign with a plurality of roll passes, i.e. transits through the roll, e.g. two, three, four, five, six, seven, eight, nine, ten, eleven or more, and interim heat treatment may take place between each of the rolling campaigns. According to certain embodiments, interim heat treatment always takes place between two steps of rolling-out in each case, including, for example, between two rolling campaigns, e.g. three rolling campaigns. For the production of thin foils having thicknesses in the range of 5 - 50 µm, preferably 8 - 30 µm, more particularly 10 - 26 µm, from hard-to-roll material containing Al, Mg, Sc, and Zr, production by means of cold rolling with a sequence involving multiple interim heat treatment is especially suitable, which makes it possible in particular for the material to be processed to the required thicknesses.

The single or multiple interim heat treatment takes place at a temperature of 200 - 450°C for a period of 3 - 6 h, as for example at a temperature of 220-350°C, preferably 290-330°C, e.g. around 325°C, and/or for a period of e.g. 4 h. There are no particular limitations on the nature of the interim heat treatment, which may suitably be accomplished by heating, for example. In terms of the time-temperature regime, the interim heat treatments or interim heat treatment are designed in particular such that the strengthening effects introduced as a result of the rolling operation are removed without any substantial influencing of the overall microstructure such as the phase composition, phase fractions, etc. The overall sequence and also the number of interim heat treatments here may be adapted on a case-by-case basis to the available starting thicknesses and/or the required final thicknesses.

According to one development, the method of the invention may further comprise a heat treatment, after the rolling-out, at a temperature of 250 - 350°C, preferably 275°C-325°C. Here again, there are no particular limitations on the heat treatment, which may likewise comprise suitable warming and/or heating. With the optional heat treatment, in a final heat treatment, for example, the microstructure can be influenced in a targeted way.

According to one development, after having been rolled out and optionally heat treated one or more times, either for example by interim heat treatment and/or final heat treatment, the metal foil is punched and/or stamped. The punching and/or stamping, which are not subject to any particular limitations, make it possible, for example, to produce a suitable shape for a connector, e.g. for solar cells, e.g. in aerospace.

Described and not according to the invention is a metal foil produced by the method of the invention. Apart from the thickness, there are no further limitations on the form of the foil. For example, the metal foil may be in the form of a cell connector for solar cells, in which case, in developments, this connector may further comprise additional constituents which are customary in such cell connectors.

Also described and not according to the invention is a solar cell array comprising the metal foil in the form of a cell connector. There are no particular limitations otherwise on the solar cell array, provided that it comprises solar cells and can be produced appropriately, it being possible in particular for the metal foil to be welded in the form of a cell connector onto a solar cell. The solar cell array can be used across a host of different sectors where such energy recovery is desired, including, for example, at considerable height, for instruments on high mountains, for example, but especially in aerospace, particularly in satellites or similar devices which may be located, for example, in an orbit around the Earth. Described and not according to the invention as well is a satellite comprising a solar cell array described, there being no particular limitations on the other constitutes of the satellite.

Also described and not according to the invention is the use of a metal foil described in a solar cell array and/or in aerospace, especially in a satellite.

The innovative value chain according to the invention, from the material through to the end product, guarantees a substantially longer product lifetime, particularly of solar cells, solar cell panels and satellite missions, and likewise guarantees improved economics in relation to automated production technology.

The above embodiments and developments may be combined with one another in any desired, rational way. Further possible embodiments, developments and implementations of the invention also encompass combinations, not explicitly stated, of features of the invention that are described above or hereinafter in relation to the exemplary embodiments. In particular, the skilled person will also add individual aspects, as improvements or additions, to the respective basic form of the present invention here.

The present invention is elucidated in more detail below with reference to the exemplary embodiments that are shown in the schematic figures, in which:
- Fig. 1: shows a schematic representation of the method of the invention;
- Fig. 2: shows a schematic representation of two solar cells connected by a metal foil of the invention in the form of a cell connector;
- Fig. 3: shows experimental results of tensile strengths achieved with a metal foil of the invention;
- Fig. 4: shows schematically an experimental arrangement for a tensile test in an example according to the invention;
- Fig. 5: shows results of sputter rates with perpendicular incidence of Xe ions with a metal foil of the invention and one of the prior art; and
- Fig. 6: shows results of S-n curves for a foil of the invention, in comparison to one of the prior art.

The appended figures are intended to convey a further understanding of the embodiments of the invention. They illustrate embodiments and serve in connection with the description to explain principles and concepts of the invention. Other embodiments and many of the stated advantages are apparent in relation to the drawings. The elements in the drawings are not necessarily shown true to scale with respect to one another.

In the figures of the drawing, elements, features and components which are identical, have the same function and have the same effect are each labelled - unless otherwise stated - with the same reference symbols.

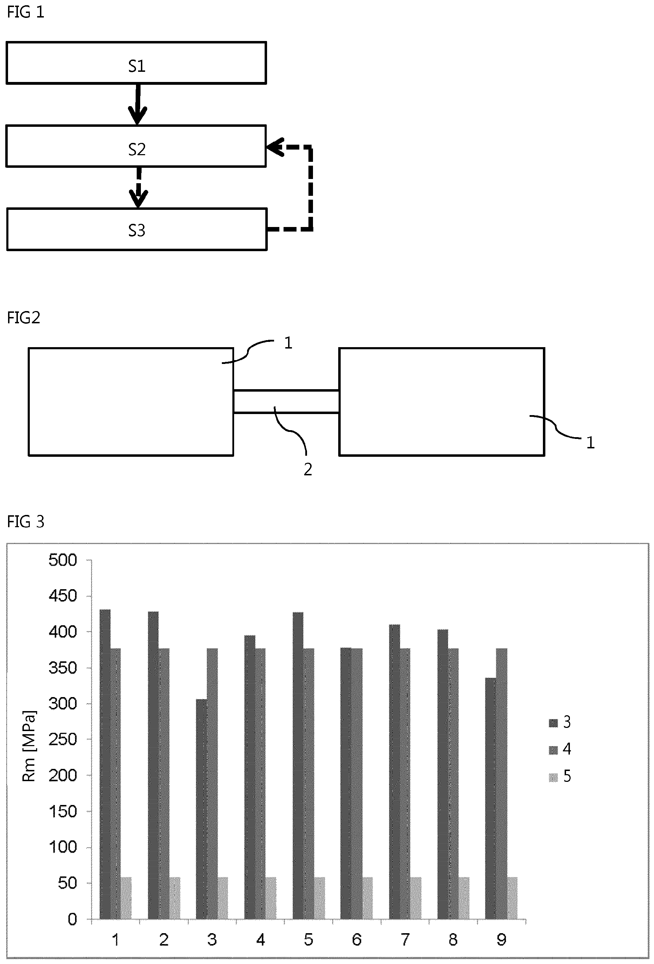

Fig. 1 shows schematically a method for producing thin metal foils of the invention, down to a final thickness of around 10 µm, from an alloy from the 5xxx group with scandium and zirconium selected from aluminium alloys from groups AA5024 and/or AA5028, the method comprising the following steps:
- A step S1 of providing an intermediate, e.g. a sheet, from the alloy group 5xxx with scandium and zirconium selected from aluminium alloys from groups AA5024 and/or AA5028, such as 5024 (KO8242) or 5028 (KO8542), for example, for example with a thickness of around 0.2 mm to 6 mm and a length in the longest dimension of at least 1000 mm;
- At least one step S2 of hot rolling and/or cold rolling in the intermediate; and
- At least one step S3 of subjecting the intermediate to interim heat treatment, and the intermediate is rolled again afterwards.

The metal foil can therefore be realized from intermediates in a plurality of steps by hot rolling/cold rolling, with interim heat treatments in the case of a plurality of rolling steps, the intermediates having been produced, for example, by conventional ingot metallurgy (IM) or powder metallurgy (PM) or by various tape casting processes, and possibly also machined to form roll bars.

By means of the interim heat treatment or treatments, in the temperature range of around 200-450°C for 3-6 h, the strengthening of material from the rolling operation and also from the precipitation hardening can be reduced in order to allow rolling to take place to the final thickness (5 - 50 µm, e.g. 10, 18, 20 or more µm) in a plurality of steps or at least with one step.

Directly after rolling, the material may have a tensile strength/yield point of more than 300 MPa, but preferably more than 350 MPa or even higher, with values for elongation at break possibly lying in the range above 0%, preferably above 0.10%.

The properties of the material may further be improved by means of optional thermal aftertreatment in the temperature range of 250 - 350°C.

The metal foil may subsequently be punched out and/or stamped in order to provide a connector 2 as shown schematically in Figure 2 which is able, for example, to connect two solar cells 1, in the case of a series connection, for example. For this purpose, the connector may be welded onto the solar cells, for example. This connector with the solar cells may then be used, for example, to operate a satellite.

The technical solution of the invention relates to the production of thin foils, with a thickness for example, of up to 5 µm, e.g. a thickness of up to approximately 10 µm, and also to the value chain to the point at application of connectors made from these thin foils by means of welding techniques to solar panels. The weldable, corrosion-resistance, thin metal foils are resistant to atomic oxygen (ATOX). Furthermore, in the temperature range from minus 196°C to around plus 400°C, the material possesses high electrical conductivity, thermal stability, ion resistance, and excellent fatigue characteristics. It is therefore possible to achieve a greater long-term stability for solar panels, especially for satellites.

It has emerged in particular that the Scalmalloy^{®} materials technology, i.e. aluminium-magnesium alloys with scandium and zirconium, in the form of thin foils, represents a good alternative to solar cell connectors and is suitable for future satellite panels. With the new technology for the connectors it is possible to ensure more than 2 000 cycles in the temperature range of around -190°C to 200+°C for GEO (geostationary orbit) missions and up to around 100 000 cycles for LEO (low Earth orbit) missions in the temperature range from around -160°C to + 150°C.

The invention hereinafter is elucidated further using an exemplary embodiment; this exemplary embodiment does not limit the invention.

### Example:

A metal foil 11 µm thick was produced from a KO8242 sheet having a thickness of 0.4 mm, by means of cold rolling and multiple interim heat treatment at 325°C for 4 h. In this case, in a first roll campaign with a number of roll passes at a speed of 5-8 m/min, the sheet was rolled to 80 µm, then subjected to interim heat treatment, rolled in a second rolling campaign with a number of roll passes at a speed of 5-8 m/min, from 80 to 18 µm, then again subjected to interim heat treatment, after which it was rolled from 18 to 11 µm in a third rolling campaign with a number of passes at a speed of 10 - 15 m/min. The hardnesses [HV01] resulting in these operations were as follows: after the first rolling campaign: 170; after the first interim heat treatment: 110; after the second rolling campaign: 130; after the second interim heat treatment: 100; after the third rolling campaign: 100. It may be noted in this regard that the same results are also obtained if rolling is carried out to 26 µm in the second rolling campaign and to 20 µm in the third rolling campaign.

### Tensile test

Tensile tests were carried out with the 11 µm foil. The tensile test results on the 11 µm KO8242 foil are shown in Fig. 3, with a mean tensile strength Rm of 378 MPa for the nine repetitions carried out. Fig. 3 shows the result 3 of the respective measurement, the mean 4 and the standard deviation 5.

### ATOX stability

Furthermore, the ATOX stability of the foil was considered for use. KO8242 is notable for excellent resistance to atomic oxygen (ATOX), which occurs, for example, in low Earth orbit. Because the outstanding mechanical properties of this alloy are produced by nm-sized, coherent precipitates, the surface of KO8242 corresponds to that of a pure AlMg alloy without extensive precipitates, which can be transferred correspondingly to the present metal foil. The atomic oxygen fluence in a 500 km orbit is, for example, 3.6E20 oxygen atoms/cm². For KO8242, accordingly, there is no measurable erosion by ATOX, whereas Ag under the same conditions undergoes erosion of 38 µm (source for all data: SPENVIS, www.spenvis.oma.be/spenvis).

### Weldability test

In order to test the weldability, a strip of the KO8242 metal foil was cold-welded as a solar cell connector to the weld contacts of a solar cell, consisting of silver with a thin gold layer, for example, by ultrasonic welding.

The solar cell connector for this test at the weld point consisted of four individual "fingers", parallel strips with a width of 1.25 mm. Each finger was fixed with a welding spot measuring 0.3×09.9 mm² on the 7×1 mm² welding pad of the cell. The four individual fingers of the solar cell connector end in a common base 6.25 mm wide, which was clamped in for the tensile test. In the tensile test, therefore, tension was applied to all four fingers simultaneously.

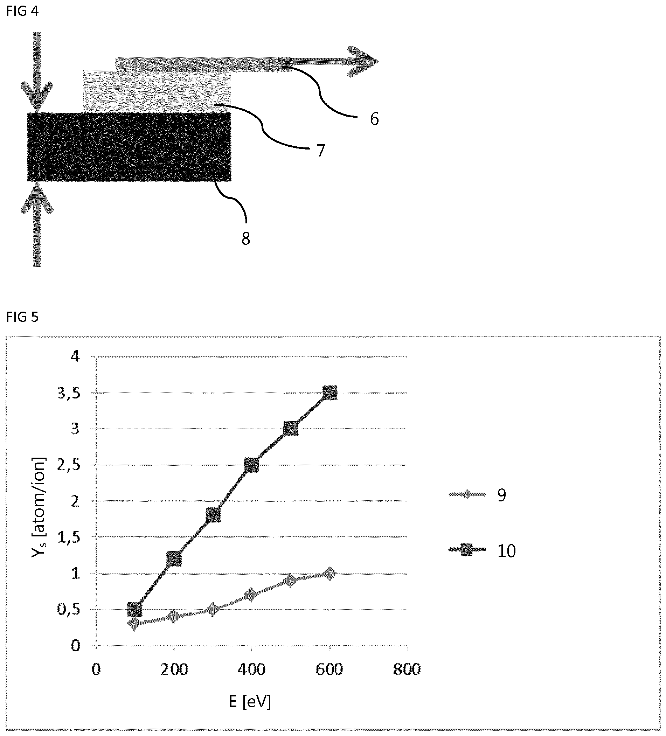

The tensile strengths achieved in this test at a tensioning angle of 0°, as shown schematically in Figure 4, with connector 6, contact 7 and solar cell 8, are > 5N.

### Thermal cycling test

In order to test the fatigue resistance of solar cell connectors manufactured from the 11 µm KO8242 foil under conditions as close as possible to their subsequent use in orbit, a thermal cycling test was designed in which seven substrates were in each case connected with six connectors by welding, in triplicate. The connectors here consisted of pairs of parallel metal strips, 2 mm wide, which were welded in each case individually to the substrate. The dimensions of the actual weld point were 0.3×0.9 mm². The three "strings" each of seven substrates were adhered to a carbon fibre sandwich structure and introduced perpendicularly into a controllable temperature chamber. The thermomechanical loading acting on the connectors by the solar cells expanding and contracting at temperature was simulated here by means of metallized germanium substrates. Through the change in temperature, the cyclical load component arising from the coefficient of linear expansion of the material, and also any possible changes in material, were also simulated. The size of the individual germanium substrates was 4 × 5 cm. The key dimension here was the width of 4 cm (parallel to the connector direction), since this defines the magnitude of the cyclical load. The temperature range covered -175°C to +130°C. A total of 12 000 cycles were carried out. For comparison, other materials as well, such as silver and pure aluminium, were tested in identical configurations.

The solar cell connectors were inspected visually for cracks or tears. While the silver connectors had undergone partial cracking, those with KO8242 were intact. In comparison, a significantly higher fatigue resistance of the KO8242 connectors was found, relative to the silver connectors typically used, and also, as expected, to the pure aluminium. Hence none of 24 KO8242 connectors failed, whereas 10 out of 24 were cracked in the case of silver, and 19 out of 24 in the case of aluminium.

### Erosion test

In order to determine the resistance to erosion by Xe ions of the kind emitted, for example, by position control drives on satellites, the sputter rates under normal/perpendicular incidence of Xe in the relevant energy rate E < 1000 eV of KO8242 were ascertained and compared with those of Ag. The Xe ions were shot from a standard ion source with defined energy, in a parallel beam, onto the foil as target material. The entire measurement took place under vacuum. By changing the angle of incidence relative to the substrate and also the energy of the ion beam, it was possible to measure the overall energy and angular dependency of the sputter rates. The sputter rate was determined in each case by measuring the decrease in weight of the target foil.

As can be seen from Figure 5, the sputter rates Yₛ in atoms per ion are better by a factor of approximately 3 for KO8242 than for Ag. This greater erosion resistance can be utilized, for example, for more effective orientation of the position control drives in North-South direction, resulting in better efficiency and lower consumption of Xe.

### Shake test

In order to quantify the greatly improved fatigue resistance of the KO8242 connectors, connectors were stamped in the geometry actually used (out-of-plane loop of 430 µm) and exposed in a special apparatus to cyclical mechanical loads of +/- 60 µm to +/- 100 µm. A number of connectors were clamped simultaneously in one apparatus, simulating the variation in the distance of two solar cells in orbit. For this purpose, one clamped-in part (corresponding, for example, to the reverse face of the cell) is held fixed in location, while the other is deflected from the position at rest, by the desired cyclical load, using a piezoelectric crystal. The clamping of the connectors on this side also takes account of the actual height offset of the connector on an actual solar panel. A current is sent individually through all the connectors, allowing the breakage of the connector to be detected via the measurement of the drop in voltage.

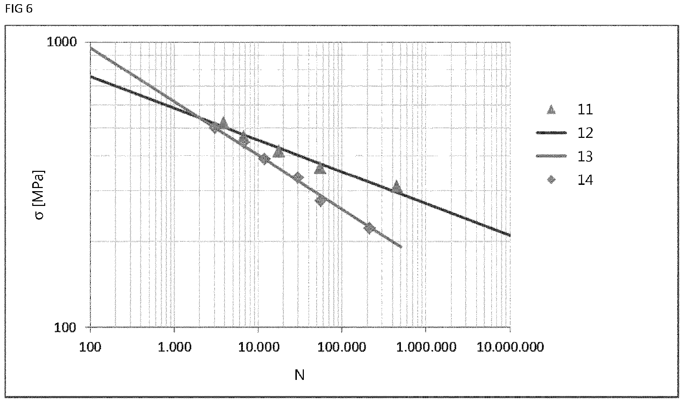

For each of these loading stages, the number of cyclical loads (N; number of cycles) was determined to the breakage point for each of 16 connectors. Finite Element Modelling (FEM) was used to compute the maximum stresses (σ) which occur in the connector loop during each of the cyclical load stages. This data can be used to construct a classic S-n curve, which is shown in Figure 6 for KO8242, with the actual data 11 for KO8242 and also a fitted curve profile 12, and, for comparison, that of silver with the fitted curve profile 13 and the actual values 14, a connector material from the prior art. The superior cycling stability within a wide voltage range is clearly apparent.

### List of reference symbols

- S1: Provision of an intermediate
- S2: Cold and/or hot rolling
- S3: Interim heat treatment

- 1: Solar cell
- 2: Connector
- 3: Tensile strength in the example
- 4: Mean tensile strength
- 5: Standard deviation
- 6: Connector
- 7: Contact
- 8: Solar cell
- 9: Sputter rate of KO8242
- 10: Sputter rate of Ag
- 11: Actual values of KO8242 in the shake test
- 12: Fitted curve of KO8242 in the shake test
- 13: Fitted curve of Ag in the shake test
- 14: Actual values of Ag in the shake test

## Claims

1. Method for producing a metal foil composed of an aluminium-magnesium alloy which comprises scandium and zirconium, comprising
Provision of an intermediate of an aluminium-magnesium alloy which comprises scandium and zirconium; and
Rolling-out of the intermediate by hot and/or cold rolling to a thickness of 5 to 50 µm, wherein the rolling-out of the intermediate takes place in a plurality of steps, wherein at least once between two steps of the rolling-out there is an interim heat treatment at a temperature of 200 - 450°C for a period of 3 - 6 h, and wherein the aluminium-magnesium alloy which comprises scandium and zirconium is selected from aluminium alloys from groups AA5024 and/or AA5028.

2. Method according to Claim 1, further comprising a heat treatment, after the rolling-out, at a temperature of 250 - 350°C.

3. Method according to any of the preceding claims, wherein the rolling takes place at a rolling speed of less than 50 m/min.

4. Method according to any of the preceding claims, wherein the metal foil, after the rolling-out and optionally a heat treatment, is punched and/or stamped.

## Patentansprüche

1. Verfahren zum Herstellen einer Metallfolie aus einer Aluminium-Magnesium-Legierung, welche Scandium und Zirconium umfasst, umfassend
Bereitstellen eines Halbzeugs einer Aluminium-Magnesium-Legierung, welche Scandium und Zirconium umfasst; und
Auswalzen des Halbzeugs mittels Warm- und/oder Kaltwalzen auf eine Dicke von 5 bis 50 um, wobei das Auswalzen des Halbzeugs in mehreren Schritten erfolgt, wobei mindestens einmal zwischen zwei Schritten des Auswalzens ein Zwischenglühen bei einer Temperatur von 200 - 450 °C für einen Zeitraum von 3 - 6 h erfolgt und wobei die Aluminium-Magnesium-Legierung, welche Scandium und Zirconium umfasst, aus Aluminiumlegierungen der Gruppen AA5024 und/oder AA5028 ausgewählt ist.

2. Verfahren nach Anspruch 1, ferner umfassend ein Glühen nach dem Auswalzen bei einer Temperatur von 250 - 350 °C.

3. Verfahren nach einem der vorhergehenden Ansprüche, wobei das Walzen bei einer Walzgeschwindigkeit von weniger als 50 m/min erfolgt.

4. Verfahren nach einem der vorhergehenden Ansprüche, wobei die Metallfolie nach dem Auswalzen und gegebenenfalls einem Glühen gestanzt und/oder geprägt wird.

## Revendications

1. Procédé de production d'une feuille métallique composée d'un alliage aluminium-magnésium qui comprend du scandium et du zirconium, comprenant
la fourniture d'un intermédiaire d'un alliage aluminium-magnésium qui comprend du scandium et du zirconium ; et
le roulage de l'intermédiaire par roulage à chaud et/ou à froid jusqu'à une épaisseur de 5 à 50 um, dans lequel le roulage de l'intermédiaire a lieu en une pluralité d'étapes, dans lequel, au moins une fois entre deux étapes du roulage, il y a un traitement thermique intermédiaire à une température de 200 - 450 °C pendant une période de 3 - 6 h, et dans lequel l'alliage aluminium-magnésium qui comprend du scandium et du zirconium, est sélectionné parmi des alliages d'aluminium des groupes AA5024 et/ou AA5028.

2. Procédé selon la revendication 1, comprenant en outre un traitement thermique, après le roulage, à une température de 250 - 350 °C.

3. Procédé selon l'une quelconque des revendications précédentes, dans lequel le roulage a lieu à une vitesse de roulage inférieure à 50 m/min.

4. Procédé selon l'une quelconque des revendications précédentes, dans lequel la feuille métallique, après le roulage et éventuellement un traitement thermique, est perforée et/ou estampillée.
